# EUROPEAN PATENT SPECIFICATION

(11) **EP 4 015 899 B1**
(45) Date of publication and mention of the grant of the patent: **04.09.2024**
(21) Application number: 20214005.9
(22) Date of filing: 15.12.2020
(51) Int. Cl.: G02B 3/00, G02B 27/01, G02B 27/00

(54) **OPTIMIZATION OF BEAM SHAPING FOR LIGHT EMITTING DISPLAYS**
OPTIMIERUNG DER STRAHLFORMUNG FÜR LICHTEMITTIERENDE ANZEIGEN
OPTIMISATION DE MISE EN FORME DE FAISCEAU POUR AFFICHAGES ÉLECTROLUMINESCENTS

(43) Date of publication of application: 22.06.2022
(73) Proprietor: Micledi Microdisplays BV, 3001 Leuven (BE)
(72) Inventor: Mityashin, Alexander, 3001 Leuven (BE); Steudel, Soeren, 3050 Oud-Heverlee (BE)
(74) Representative: Körfer, Thomas

(56) References cited:
- EP-A1- 3 667 720
- WO-A1-2010/057219
- US-A1- 2015 268 399
- US-A1- 2015 362 165
- US-A1- 2017 285 346
- US-A1- 2019 250 405
- US-A1- 2019 377 122

## Description

The invention relates to optimization of beam shaping for light emitting displays, especially micro-LED displays in order to achieve uniform light out-coupling from holographic waveguides, especially in augmented reality (AR), virtual reality (VR), and mixed reality (MR) applications.

Generally, micro-LED displays offer numerous advantages such as high efficiency, long lifetime, wide color range, and comparatively cheaper production cost, which results in the wide range of implementation of such displays especially in AR, VR and MR headsets. However, the typical light distribution of an LED shows distinct Lambertian profile, which is not optimal or efficient to achieve a homogeneous illuminance at a target plane. In order to achieve an adapted beam profile, beam shaping, especially beam shaping per pixel of the micro-LED display is implemented that addresses the transformation of a given light distribution into a customized form.

For example, the document EP 3 667 720 A1 shows an LED device with an LED array having a LED pixel pitch in the micrometer range. The emission angle of the light provided by the LED device is reduced compared to an emission angle of the light output from the LED array, especially by implementing pixel level beam shaping. However, the light beam of every pixel of the display has still an angular distribution that leads to a lateral dispersion, for instance, at the out-coupling grating of a holographic waveguide between different angles of the same pixel. Different angles or different wavelength might even encounter a different number of reflections in the waveguide and therefore a difference in attenuation. This may lead to the variation in intensity of the out-coupled light depending on which angle is perceived by the eye.

US 2015/268399 A1 discloses a method for optimizing beam shaping of a display, a system for optimizing beam shaping of a display and a display.

Accordingly, the object of the invention is to provide a method and a display system for addressing the aforementioned limitations.

The object is solved by the features of the independent claims. The dependent claims contain further developments.

According to a first aspect of the invention, a method is provided for optimizing beam shaping of a display comprising an array of light emitting elements, each corresponds to a pixel of said display, in order to adjust angular distribution of light pattern in an optical waveguide. The method comprises the step of simulating a luminance distribution for positional and angular characteristics of luminance of the optical waveguide. This is particularly achieved by simulating the optical waveguide attenuation and optimal diffraction efficiency for every eye-box position across the full eye-box area for every color. The method further comprises the step of measuring a luminance distribution for positional and angular characteristics of luminance of the optical waveguide.

The method further comprises the step of comparing the simulated luminance distribution with the measured luminance distribution of the optical waveguide. In addition, the method further comprises the step of defining an optimum emission pattern for every pixel for every color of the display based on the simulated and measured luminance distribution. Furthermore, the method comprises the step of realizing a lens geometry per pixel of the display from the optimum emission pattern.

Moreover, the method comprises the step of processing a lens system per pixel of the display based on the realized lens geometry in a digital process. As opposed to analog lens shaping, digital lens shaping process (e.g. damascene process) relies on step height and width variations of high index to low index materials (e.g. metalens, Fresnel lens, holographic optical element, diffractive optical element, and so on) .

Therefore, the variations in light intensity caused by the attenuation and diffraction of the waveguide are compensated by modifying the beam shape of every individual pixel of the display, e.g., a micro-LED display, by wafer level optics, especially by realizing an arbitrary shaped digital lens in a high index material on top of each individual LED pixel. The inventive solution is particularly advantageous for the case when the optics is based on a waveguide technology with pupil expansion and with a micro-LED display as light source, where the inventive solution allows for arbitrary shapes of pixel level lens based on co-optimization with the waveguide design. In this regard, the term "optics" is referred to combiner optics that guides the light to different eye boxes, which contains additional sub-solution for pupil expansion. However, the inventive solution is not limited to the waveguide technology and is also advantageous for the case when the optics is based on free space or guided space.

According to a first preferred implementation form of said first aspect of the invention, the measurement of luminance distribution comprises the step of measuring the luminance distribution with respect to a plurality of predefined test points on the optical waveguide. Said test points are preferably scattered through the out-coupling grating or surface of the waveguide, where the measurement preferably comprises the measurements of luminance distribution for different viewing angles, e.g., left edge, center, and right edge. Advantageously, a high degree of accuracy is perceived in order to identify luminance variation of the out-coupling lights via optical measurements or simulations of the waveguide.

According to a second preferred implementation form of said first aspect of the invention, the definition of optimum emission pattern comprises the step of defining an optimum emission pattern per pixel, per color of the display with respect to the relative position of the micro-LED display and the optical waveguide. Advantageously, the light emission profile for each pixel is optimized in order to compensate for different attenuation by the waveguide at each position and each relevant angle for every color to enable stable color mixing.

According to a further preferred implementation form of said first aspect of the invention, the realization of lens geometry comprises the steps of defining, in ray tracing, the respective positioning of the display and the optical waveguide, optimizing an offset and a shape of the lens system thereby obtaining the lens geometry in arbitrary functions until the optimum emission pattern is achieved, and translating the lens geometry into a digital pattern, thereby realizing digital arbitrary shaped optics. Advantageously, a beam shape or emission lobe per pixel closest to the target beam shape can be achieved with the best light out-coupling efficiency.

According to a further preferred implementation form of said first aspect of the invention, the processing of the lens system comprises the steps of depositing a low index material onto the surface of the light emitting elements, especially light emitting diodes, dry-etching with a masking pattern based on the realized lens geometry, and refilling with a high index material, where the index is preferably close to the index of the light emitting diode material. Additional planarization steps (CMP) or adding layers that work as etch stop for the dry etch process need to be foreseen. Alternatively, a multi-step dry etch process in a high index material can be implemented using a thick resist as the dry etch mask, whereby the low index material is air.

Additionally, it is further conceivable that the processing sequence of depositing low index material and high index material can be implemented in an opposite manner. For instance, it is conceivable that the high index material may be deposited onto the surface of the light emitting elements, dry-etched with a masking pattern based on the realized lens geometry, and then refilled with a low index material.

According to a further preferred implementation form of said first aspect of the invention, the method further comprises the step of verifying the lens geometry per pixel in a Finite-difference time domain simulation. Additionally or alternatively, however not according to the claimed invention, the method further comprises the step of verifying the lens geometry for a cluster of pixels in a Finite-difference time domain simulation. Advantageously, the accuracy for optimizing the shape of the lens system is further improved, since the interference patterns can be taken into consideration in Finite-difference time domain simulations.

According to a second aspect of the invention, a system is provided for optimizing beam shaping of a display comprising an array of light emitting elements, each corresponds to a pixel of said display, in order to adjust angular distribution of light pattern in an optical waveguide. Said system comprises simulation means configured to simulate a luminance distribution for positional and angular characteristics of luminance of the optical waveguide. The system further comprises measuring means configured to measure a luminance distribution for positional and angular characteristics of luminance of the optical waveguide.

Moreover, the system comprises processing means configured to compare the simulated luminance distribution with the measured luminance distribution of the optical waveguide. In addition, the processing means is further configured to define an optimum emission pattern for every pixel for every color of the display based on the simulated and measured luminance distribution. Furthermore, the processing means is configured to realize a lens geometry per pixel of the display from the optimum emission pattern. The system moreover comprises fabrication means configured to process a lens system per pixel of the display based on the realized lens geometry in a digital process.

Therefore, the variation in light intensity caused by the attenuation and diffraction of the waveguide are compensated by modifying the beam shape of every individual pixel of the display by wafer level optics, especially by realizing arbitrary shaped lens per pixel of the display based on the property, e.g., diffraction efficiency, of the waveguide.

According to a further preferred implementation form of said second aspect of the invention, the processing means is further configured to define, in ray tracing, the respective positioning of the display and the optical waveguide. In addition, the processing means is further configured to optimize an offset and a shape of the lens system, thereby obtaining the lens geometry in arbitrary functions until the optimum emission pattern is achieved. Moreover, the processing means is further configured to translate the lens geometry into a digital pattern, thereby realizing digital arbitrary shaped optics. Advantageously, a beam shape or emission lobe per pixel closest to the target beam shape can be achieved with the best light out-coupling efficiency.

According to a further preferred implementation form of said second aspect of the invention, the fabrication means is further configured to process the lens system by depositing a low index material onto the surface of the light emitting elements, especially light emitting diodes, dry-etching with a masking pattern based on the realized lens geometry, and refilling with a high index material, where the index is preferably close to the index of the light emitting diode material. Additional planarization steps (CMP) or adding layers that work as etch stop for the dry etch process need to be foreseen. Alternatively, a multi-step dry etch process in a high index material can be implemented using a thick resist as the dry etch mask, whereby the low index material is air.

According to a third aspect of the invention, a display is provided. The display comprises an array of light emitting elements; each corresponds to a pixel arrangement of the display. The pixel arrangement comprises a light emitting element for each pixel. The pixel arrangement further comprises a lens system comprising a digital arbitrary shaped optics optically coupled on top of each light emitting element, wherein the digital arbitrary shaped optics comprises at least a first layer and at least a second layer. In this context, the geometry of the lens system is optimized with a method according to the first aspect of the invention.

According to a first preferred implementation form of said third aspect of the invention, the digital arbitrary shaped optics is composed of a high index material preferably close to the index of the light emitting element material. For example, the light emitting element material, e.g., an LED composition alloy, may composed of Gallium Nitride or Aluminium Gallium Indium Phosphide with a refractive index of 2.4 or 3.4, respectively. In this regard, the choice of a high index material for the optics layers or lenses can be high index nitrides comprising Silicon (e.g., SiN), high index oxides comprising Titanium, Hafnium, Tantalum, and the like.

According to a second preferred implementation form of said third aspect of the invention, the feature size, i.e. critical dimension (CD), of the digital arbitrary shaped optics is smaller than 1/4 of the smallest wavelength emitted by the light emitting elements. The smallest permissible feature size allows for further layers, which advantageously increases the transmission efficiency of the light.

Exemplary embodiments of the invention are now further explained with respect to the drawings by way of example only, and not for limitation. In the drawings:
- Fig. 1: shows an exemplary embodiment of the method according to the first aspect of the invention;
- Fig. 2: shows light propagation in a waveguide with reflective gratings;
- Fig. 3: shows an exemplary display arrangement with a display and a waveguide with reflective hologram for pupil expansion;
- Fig. 4A: shows exemplary test points selected on the out-coupling grating of the waveguide;
- Fig. 4B: shows exemplary luminance distribution at different test points of Fig. 4A;
- Fig. 5: shows an exemplary embodiment of the system according to the second aspect of the invention;
- Fig. 6A: shows 3D Finite-difference time domain simulation of emission pattern of an LED without lens;
- Fig. 6B: shows 3D Finite-difference time domain simulation of emission pattern of an LED with spherical lens;
- Fig. 6C: shows 3D Finite-difference time domain simulation of emission pattern of an LED with aspheric lens;
- Fig. 6D: shows 3D Finite-difference time domain simulation of emission pattern of an LED with aspheric lens with 200nm center offset;
- Fig. 7: shows ray tracing process in order to define a target function by way of an example;
- Fig. 8A: shows an exemplary three layer Fresnel lens;
- Fig. 8B: shows an exemplary three layer spherical lens;
- Fig. 9: shows an exemplary process sequence to implement a two-layer Fresnel lens in a high index material;
- Fig. 10A: shows a tilted top view of a pixel level Fresnel lens implemented with a two-step dry etch process;
- Fig. 10B: shows a side view of a pixel level Fresnel lens implemented with a two-step dry etch process; and
- Fig. 11: an exemplary embodiment of the display according to the third aspect of the invention.

Reference will now be made in detail to the embodiments of the present invention, examples of which are illustrated in the accompanying drawings.

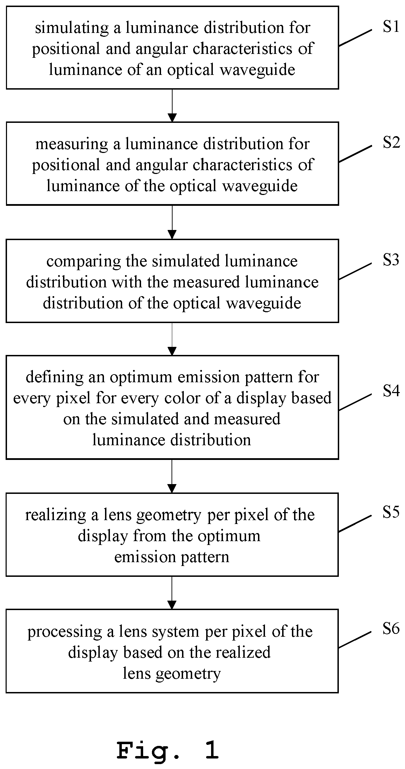

In Fig. 1, an exemplary embodiment of the method according to the first aspect of the invention is illustrated. In a first step S1, a luminance distribution for positional and angular characteristics of luminance of an optical waveguide is simulated. In a second step S2, a luminance distribution for positional and angular characteristics of luminance of the optical waveguide is measured. In a third step S3, the simulated luminance distribution is compared with the measured luminance distribution of the optical waveguide. In a fourth step S4, an optimum emission pattern is defined for every pixel for every color of a display based on the simulated and measured luminance distribution. In a fifth step S5, a lens geometry is realized per pixel of the display from the optimum emission pattern. Finally, in a sixth step S6, a lens system is processed per pixel of the display based on the realized lens geometry in a digital process.

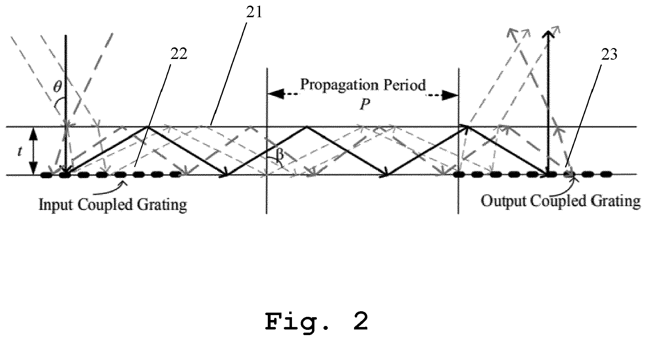

In Fig. 2, light propagation in a waveguide 21 with reflective gratings is shown. The light bounces along the waveguide 21 experiences total internal reflection (TIR) between the in-coupling grating or hologram 22 and out-coupling grating or hologram 23. The number of TIR bounces is dependent upon the separation distance between the in-coupling grating 22 and out-coupling grating 23, the thickness of the substrate, and the reconstruction angle caused by diffraction at the in-coupling grating 22. The out-coupling grating 23 then redirects the light out of the waveguide 21 in a ray bundle toward the eye of the viewer (not shown). By selecting a waveguide geometry that results in numerous TIR bounces in the waveguide 21 and an out-coupling grating 23 of sufficient width, the light will encounter the out-coupling grating 23 after multiple TIR bounces.

Further, by tailoring the diffraction efficiency of the out-coupling grating 23 to increase along the length of the grating 23, multiple light bundles of equal brightness can be directed from out-coupling grating 23. Where the ray bundle resulting from a single interaction with the out-coupling grating 23 will generate a relatively small exit pupil, the composite exit pupil generated by tiling individual exit pupils from each TIR out-coupling grating 23 interaction is much larger. This phenomenon is referred to as pupil replication or pupil expansion. Pupil replication facilitates a large eye box that allows for variation in location of the viewer's eye with a full field of viewing.

Generally, the in-coupling light beam from a light source or source display will be collimated, e.g., via a collimation lens, however the light beam of every pixel of the source display has still an angular distribution which lead to a lateral dispersion at the out-coupling grating 23 between different angles of the same pixel. Different angles or different wavelength might even encounter a different number of reflections in the waveguide 21 and therefore a difference in attenuation. This can lead to variation in intensity of the out-coupled light depending on which angle is perceived by the eye.

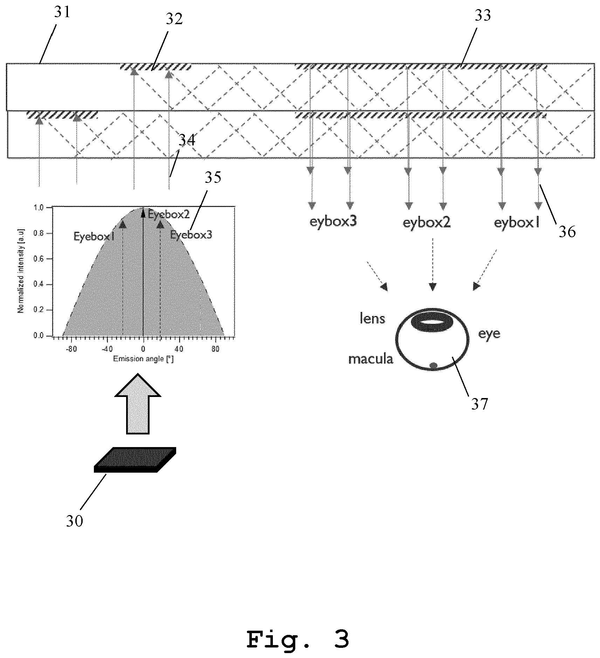

In Fig. 3 an exemplary display system with a display 30 and a waveguide 31 with reflective grating or hologram is illustrated that facilitates pupil expansion. Herein, the waveguide 31 is exemplified as a two-layer waveguide, for instance, each corresponding to the transmission of red and blue lights whereby the green light is split between the red and blue waveguide. However, it is conceivable that the waveguide 31 can comprise three layers, each dedicated for the transmission of red, blue and green light, respectively. It is further conceivable that the waveguide 31 may only have one layer, i.e., a single layer for all three colors.

The in-coupling structure 32 and the out-coupling structure 33 can hereby be transflective mirrors, surface relief gratings or volumetric holographic gratings. The light 34, shown here as a conventional profile 35, coming from the display 30, e.g. a light emitting diode or an array of light emitting diodes formed together as a source display, is generally collimated to some extent by a collimation lens, traditionally placed between the display 30 and the in-coupling structure 32 of the waveguide 31. However, as described above, the collimated light may retain an angular distribution for every pixel. The emission pattern of the light 34 is depicted here as a Lambertian function 35, as it is the archetypal emission structure for a light emitting diode without any optical modulation. However, at scaled dimension (e.g., <10 micrometers) it is more likely to have a strong deviation from the Cosines function with several reflection peaks.

There is an in-coupling structure 32, especially the special position of the in-coupling structure 32 along the waveguide 31 based on the projection arrangement of the display 30, or vice versa. For example, the display can project light either RGB pixel by pixel or RGB display by display, which decides if the in-coupling structure 32 for all waveguides is at the same location (RGB pixel by pixel) or at a separate location (RGB display by display). However, it is conceivable that if there are separate displays for separate colors, they can still create a light pattern whereby RGB is pixel by pixel if they are combined using an optical combiner, e.g. a prism, before they are collimated through a collimation lens.

The out-coupling structure 33 is preferably in diffractive nature, e.g., diffractive optical elements (DOEs), so that the in-coupling light 34 propagates along the waveguide 31 and is extracted multiple times allowing for an increased eye-box 36, thereby facilitating pupil expansion. However, depending on which direction or eye-box 36 the eye 37 is looking, the perceived light is from a different emission angle of every pixel. One possible solution is to implement a gradually changing diffraction efficiency of the out-coupling structure 33 in order to enable that every eye-box position 36 couples out the same light intensity, or at least to an amount closest to each other.

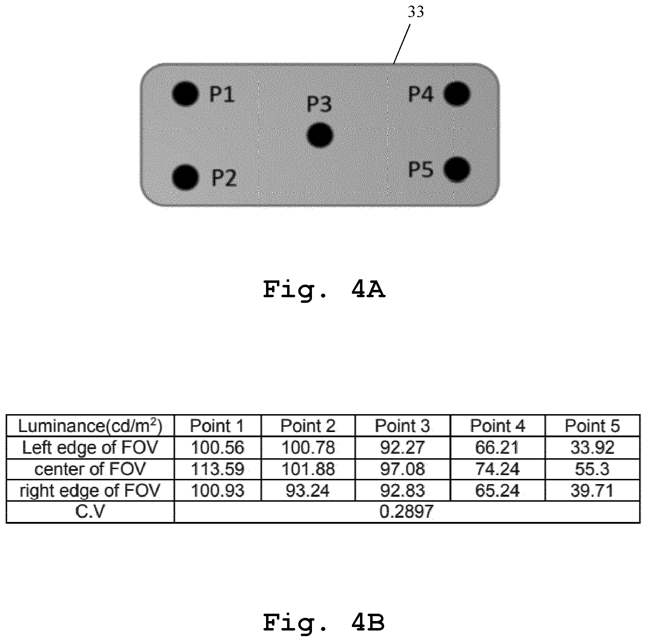

Along Fig. 4A and 4B, luminance distribution at different eye-box position with optimized diffraction efficiency is illustrated. The term optimization of diffraction efficiency reflects that the diffraction efficiency is optimized in both lateral and vertical direction in order to take into account the real number of reflection events depending on the angular and wavelength distribution of the light. In Fig. 4A, five test points are selected on the out-coupling structure 33 of the waveguide 31. Particularly, a test point P1 is selected at the top-left of the out-coupling structure 33, a test point P2 is selected at the bottom-left of the out-coupling structure 33, a test point P3 is selected at the center of the out-coupling structure 33, where the center is preferably is the point of intersection of the lateral and vertical axis. In addition, a test point P4 is selected at the top-right of the out-coupling structure 33, and a test point P5 is selected at the bottom-right of the out-coupling structure 33.

In Fig. 4B, the luminance of the out-coupled light is shown in a tabular form. The luminance distribution is simulated for an optimized diffraction efficiency of the out-coupling structure 33 for green light in a single layer waveguide 31. At each test point, the luminance is measured (in cd/m²) for left edge of field of view, center of field of view and right edge of field of view. It can be seen that even in this optimized diffraction pattern, the perceived light intensity variation for the same image under different viewing angle is up to 30% (i.e., the coefficient of variation ~0.3). For a monochrome image, this might still be acceptable since the eye is not very sensitive to relative brightness variation (i.e., different levels of grayscale values). However, for full color image where RGB lights overlap, the intensity variation is perceptible.

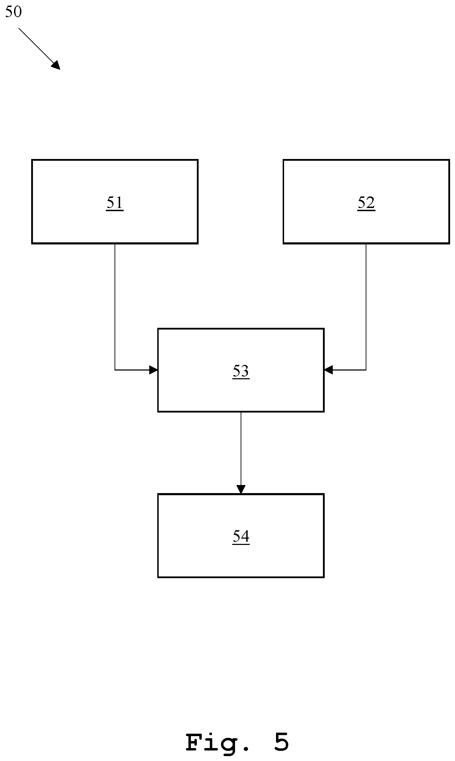

In Fig. 5, an exemplary embodiment of the system 50 according to the second aspect of the invention is illustrated. The system 50 or arrangement is preferably operable to realize an optimum geometry for beam shaping optics, especially pixel level optics onto each pixel of an input display, e.g. the display 30 of Fig. 3, especially by performing optical simulations and measurements of a waveguide, e.g. the waveguide 31 of Fig. 3, where the image is to be projected. The system 50 is further operable to perform processing the pixel level lens, especially at wafer level, onto each pixel of the input display 30.

In this context, the system 50 comprises simulation means 51 configured to simulate a luminance distribution for positional and angular characteristics of luminance of the optical waveguide 31. In addition, the system 50 comprises measuring means 52 configured to measure a luminance distribution for positional and angular characteristics of luminance of the optical waveguide 31. The luminance distribution measurement may correspond to the solution illustrated in Fig. 4A and 4B.

For instance, a predefined number of test points may be defined on the out-coupling structure 33 of the waveguide 31, and the luminance distribution can be simulated or measured or both. The measurement or simulation is preferably performed for a relative placement of the display 30 with respect to the lateral direction of the waveguide 31. This relative positioning is maintained throughout the process so that no offsetting is required once the process is completed, e.g., additional TIA bounces or attenuations due to a change in the positioning of the display 30 on the waveguide 31.

The system 50 further comprises processing means 53 configured to define an optimum emission pattern for every pixel for every color of the display 30 based on the measured and/or simulated luminance distribution, especially by comparing the simulated luminance distribution with the measured luminance distribution. Exemplary emission patterns are illustrated and are described in a later section of this description. For instance, in view of the solution illustrated along Fig. 4A and Fig. 4B, if the luminance at point P1 for left edge of field of view is 100.56 cd/m², center of field of view is 113.59 cd/m², and right edge of field of view is 100.93 cd/m². In this particular case, the processing means 53 may define an optimum emission pattern for the display 30 by offsetting the emission lobe to left and/or to right by an amount sufficient to make the luminance distribution uniform for the left edge, center and the right edge.

At this point, the processing means 53 realizes a lens geometry per pixel of the display 30 based on the optimum emission pattern, which ideally translates an arbitrary geometry since the offsetting for each pixel is different due to different luminance distribution, especially when pupil expansion is implemented. The system 50 moreover comprises fabrication means 54 or process, where the fabrication means 54 performs pixel level lens processing, preferably with a damascene process, in order to process a lens system per pixel of the display 30 based on the realized lens geometry. It is to be noted that all processes described above are required to be performed for each pixel of the display 30, i.e. per pixel implementation of the display 30.

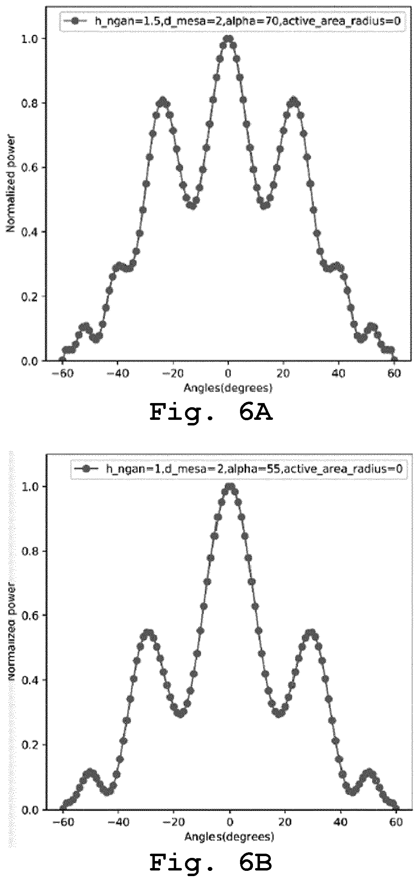

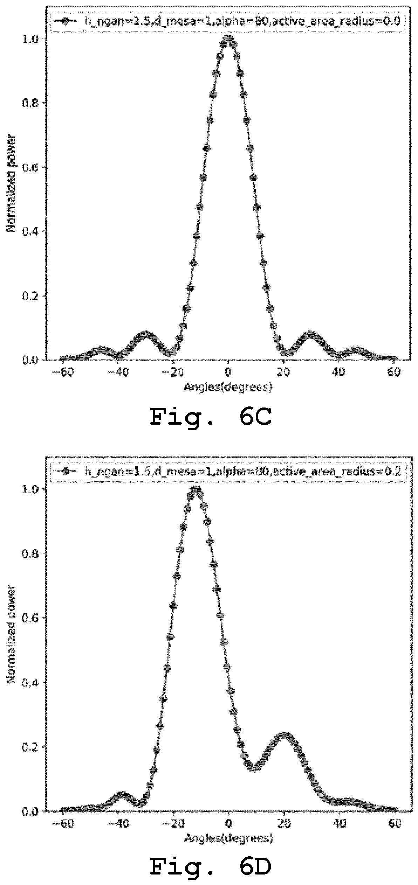

Along Fig. 6A, Fig. 6B, Fig. 6C and Fig. 6D, 3D Finite-difference time domain simulations of emission pattern of an LED are illustrated with different lens arrangement. Said LED may correspond to the display 30, in particular each or any of the individual pixel of the display 30. Particularly, Fig. 6A shows the beam shape where no lens is implemented on said pixel or LED. As can be seen, different emission lobes are present, which is already problematic when combining such an emission pattern for RGB, since the ratio of color mixing would strongly shift depending on the position of the eye-box 36 through which the eye looks.

Fig. 6B shows the beam shape where spherical lenses are implemented. As it can be seen that the use of spherical lens increases the efficiency of the light out-coupling but has limited impact on the beam shape. It is to be noted that even a spherical lens has impact on the beam shape since the ratio between center and side-lobe emissions will be increased, however, not as strongly as with an aspheric lens. As such, some form of directionality can be achieved even with a spherical lens if the lens is offset from the center of emission. Fig. 6C and Fig. 6D shows the beam shape where aspheric lenses are implemented. Particularly, Fig. 6C shows the directionality of the light out-coupling that can be achieved for a centered aspheric lens with respect to the LED and Fig. 6D shows the directionality of the light out-coupling that can be achieved with an aspheric lens, offsetting by 200nm to the center of the LED. It can be seen that an aspheric shape of the lens like these strongly modulates the beam shape.

The emission patterns illustrated along Fig. 6A, Fig. 6B, Fig. 6C and Fig. 6D are exemplary. As already mentioned above, the optimum emission pattern translates to an emission pattern that is optimum for a given pixel, where the emission patterns are evidently different for different pixels due to different attenuation and shifting. It is to be noted that only the light between -20° to +20° is relevant and is coupled into the waveguide 31. However, said range also depends on the field of view, the details of the waveguide 31, and gratings design, and may vary between 10°-30°.

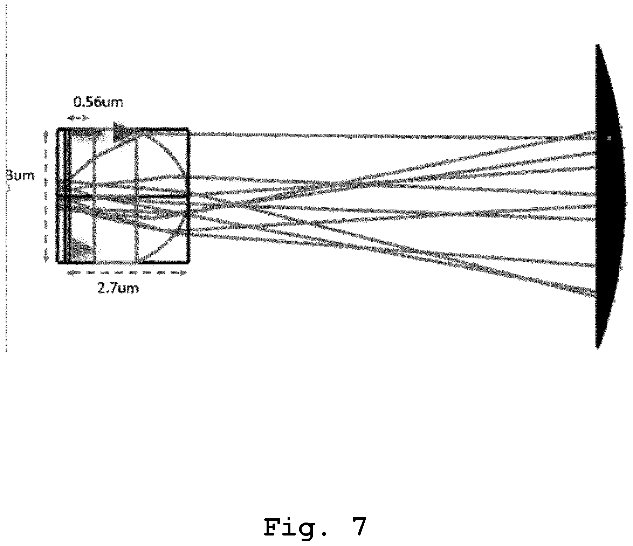

In Fig. 7, an exemplary ray tracing process is illustrated in order to define a target function that can be translated to the desired beam shape, preferably per pixel. Preferably, after the definition of an optimum emission pattern, e.g., an emission pattern according to Fig. 6C or Fig. 6D, especially based on the optical simulation obtained from the simulation means 51 and/or optical measurements obtained from the measuring means 52, the processing means 53 realizes the lens geometry based on the optimum emission pattern, preferably in ray tracing. In order to do so, the processing means 53 may define in ray tracing the pixel geometry of the display 30, i.e. the LED geometry and the position of the waveguide 31, on which the beam is to be projected. Afterwards, the processing means 53 runs optimizations to vary the lens offset and shape in arbitrary functions and further able to check which of the functions lead to a beam shape closest to the target beam shape with the best light out-coupling efficiencies.

In addition to this, the processing means 53 may further verify the obtained lens shape in Finite-difference time domain simulation. In other words, each light emitting element, i.e. the LED, corresponds to per pixel of the display 30, with the optimal lens shape obtained from ray tracing is verified in Finite-difference time domain simulation. The simulation can be done per pixel according to the claimed invention, or on a cluster of pixels (not according to the claimed invention), based on the available time and resource in hand. This is advantageous since the ray tracing does not take into account the interference patterns, which can be taken into account in the Finite-difference time domain simulation.

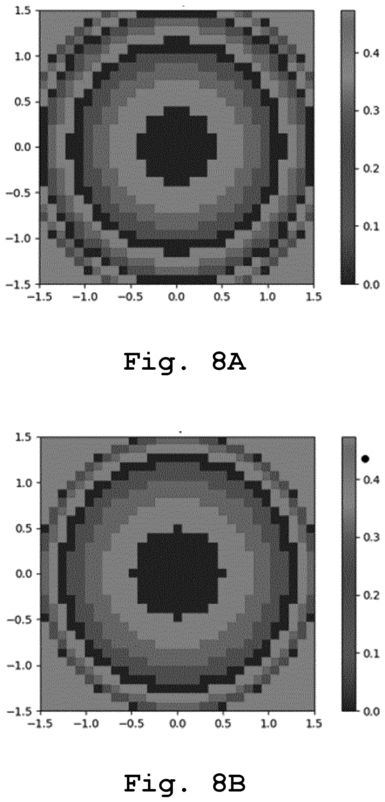

In a consequent step, the processing means 53 translates the analog lens shapes, obtained from ray tracing per pixel, in a digital pattern (e.g., metalens, HOE, Fresnel lens) by computing the required phase shift at the pitch of the litho and etch capability. For instance, in Fig. 8A and Fig. 8B exemplary three layer Fresnel lens and spherical lens with a dimension of 3 micrometers are illustrated, respectively. Especially every layer of the Fresnel lens corresponds to a phase shift of 90°, 120°, and 180°. The lenses have a pitch of 100 micrometers and are realized in TiOx. The color map stands for the height of the lens patter in nanometer at that position.

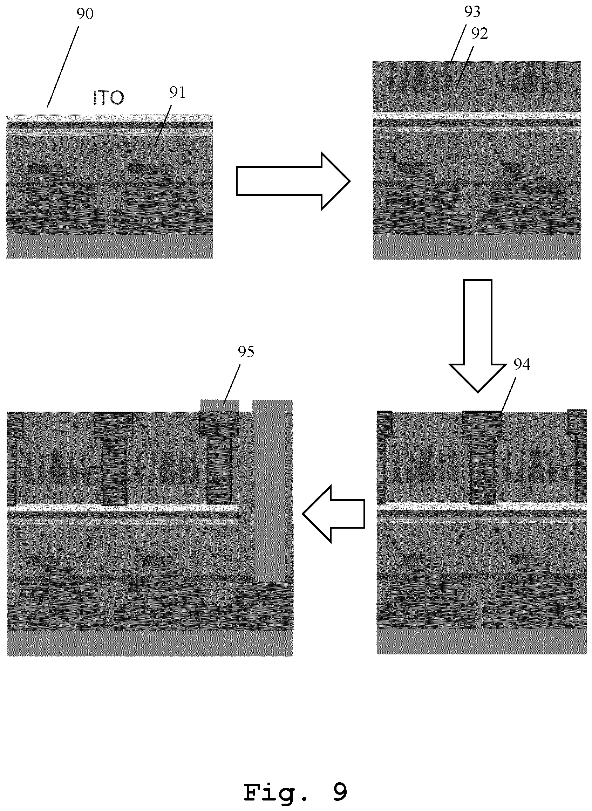

In Fig. 9, an exemplary process sequence to implement a multi-layer digital lens (e.g., a Fresnel lens) is illustrated, especially performed by the fabrication means 54 of the system 50. The process sequence corresponds to a single damascene process, which is essentially an additive process. The portion 90 of the display 30 is exemplified as two light emitting elements, i.e. two LEDs for a micro-LED display. Each LED 91 corresponds to a pixel of the display 30. For forming a first layer of the lens 92, a low index material (e.g., Sio2, FSG) is deposited onto the surface of the LED 91, especially onto the surface contact ITO.

The deposited low index material layer is then dry-etched with a masking pattern based on the lens geometry for the respective layer, especially based on the optimum lens geometry for individual LED 91. The etched low index material is then refilled with a high index material by means of chemical vapor deposition or atomic layer deposition, where the index value of the high index material is preferably close to the LED 91 material. Afterwards, a chemical mechanical planarization process is applied in order to smoothen the surface.

Similarly, for forming a second layer of the lens 93, the low index material (e.g., Sio2, FSG) is further deposited onto the smoothen surface of the first layer of the lens 92 and the deposited low index material layer is then dry-etched with another masking pattern. Based on the lens geometry for the respective layer, especially based on the optimum lens geometry for individual LED 91, the masking pattern for the second layer varies. The etched low index material is then filled again with the high index material by means of chemical vapor deposition or atomic layer deposition. Afterwards, a chemical mechanical planarization process is applied in order to smoothen the surface. For each subsequent layers, e.g. for a three layer Fresnel lens of Fig. 8A, the process sequence is repeated with a different mask based on the lens geometry of the respective layer.

Optional conductive structures 94 can be processed on top of the LED 91 surface; especially to modulate the beam shape further with a reduced apex angle, since these conductive structures 94 absorb a portion of the light emitted by the LED 91. In this case, these structures can also be processed via damascene process. The conductive structures 94 essentially improves the overall conductivity along with the ITO since the conductivity of the ITO alone is not good enough. The conductive structure can either be a single-layer structure or a dual-layer structure (when fabricated in a dual-damascene process), wherein at least one of these layers is configured to absorb the light, for instance, by being provided with an anti-reflective coating.

In this regard, the conductive structure 94 may further comprise a light absorbing layer, i.e. an anti-reflective layer, configured to absorb light emitted by the LED 91 and impinging on the surface of the conductive structure 94, i.e. absorb the light. An example for such an anti-reflective layer is a carbon layer with a thickness of e.g. 65nm, or a layer of a high refractive index material to trap light. Another alternative is a Tantalum Nitride (TaN) layer with a thickness of e.g. 20nm. This effectively forms a distributed Bragg reflector (DBR) that increases the light out-coupling in the forward direction and decreases reflections in the backward direction, thereby minimizing adverse phenomena such as light reflected into the CMOS and optical crosstalk.

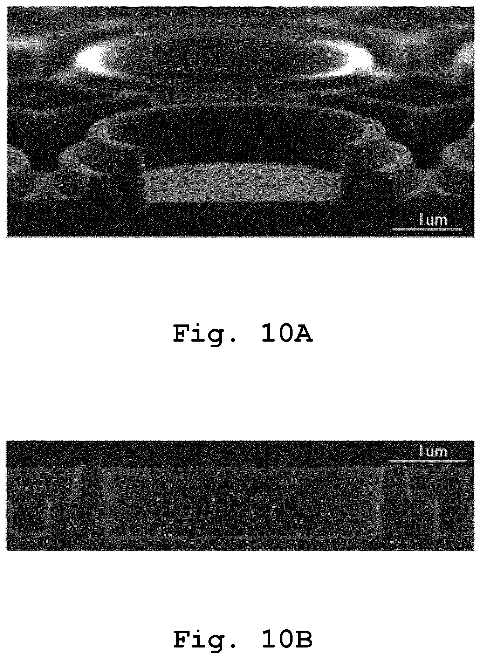

Alternatively, the above-mentioned process sequence can be implemented via two-step dry etch process. For example, Fig. 10A shows a tilted top view of a two-layer Fresnel lens and Fig. 10B shows a side view of the two-layer Fresnel lens of Fig. 10A. The two-layer Fresnel lens is fabricated on top of the individual 5.5 x 5.5 micrometers pixels with a two-step dry etch process in high index SiN using a thick resist as the dry etch mask. The low-index material is hereby air.

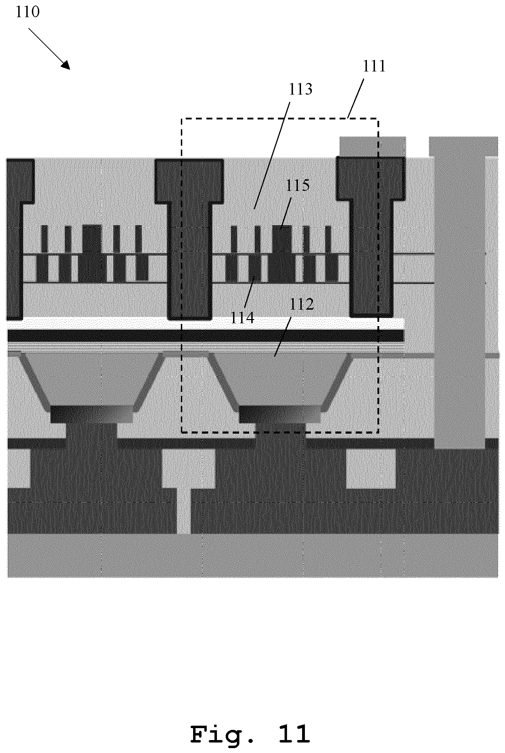

In Fig. 11, an exemplary embodiment of the display 110 according to the third aspect of the invention is illustrated. The display 110 comprises an array of light emitting elements, each corresponds to a pixel arrangement 111 of the display 110. Preferably, the display is a micro-LED display with an array of microscopic LEDs, each of the microscopic LED corresponds to a pixel of the micro-LED display.

In this context, the pixel arrangement 111 comprises a light emitting diode 112 for each pixel and a lens system 113 per pixel. The lens system 113 comprises a digital arbitrary shaped optics or digital lens optically coupled on top of the LED surface. The lens system 113 comprises at least a first layer 114 and a second layer 115, preferably more. The geometry of the lens system 113, especially the geometry for each layer of the digital lens, is realized by the system 50, especially by implementing the processes described along the second aspect of the invention.

Conveniently, the display 110 comprises microscopic lens fabricated on each pixel of the array, which is individually shaped to compensate the angle and positional dependent attenuation in the waveguide, e.g., the waveguide 31, especially for each color including the angle and positional dependent attenuation coming from any other optical element in between the display 110 and eye. The lens system 113 is realized in terms of digital arbitrary shaped optics (Metalens, Diffractive Optical Element, Holographic Optical Element, Fresnel lens, etc.) without the necessity of symmetry, and is realized for each pixel to shape the emission pattern coming from the LED 112.

In addition, the feature size of the digital lens is smaller that quarter of the smallest wavelength emitted by the LED 112, e.g., a feature size less than 1/4 lambda results in less than 100 nanometers for blue LED. It is particularly advantageous since the smaller the feature size of the digital lens structure, more layers can be fabricated, which results in the more efficient transmission of the light, especially the typical scattering losses in digital lenses can be significantly minimized with each additional layer. The present invention concerns in the field of AR, VR and MR applications, especially AR, VR and MR headsets, in which the optics are based on a waveguide technology with pupil expansion and with a micro-LED display as light source. The inventive solution is to adjust angular distribution of light pattern in the waveguide to achieve uniform light out-coupling by modifying the beam shape of every individual pixel of the display by wafer level optics, especially by creating an arbitrary shaped digital lens in a high index material on top of each individual LED pixel.

The embodiments of the present invention can be implemented by hardware, software, or any combination thereof. Various embodiments of the present invention may be implemented by one or more application specific integrated circuits (ASICs), digital signal processors (DSPs), digital signal processing devices (DSPDs), programmable logic devices (PLDs), field programmable gate arrays (FPGAs), processors, controllers, microcontrollers, microprocessors, or the like.

## Claims

1. A method for optimizing beam shaping of a display (30) comprising an array of light emitting elements, each corresponds to a pixel of said display, in order to adjust angular distribution of light pattern in an optical waveguide (31), wherein the method comprises the steps of:
simulating (S1) a luminance distribution for positional and angular characteristics of luminance of the optical waveguide (31),
measuring (S2) a luminance distribution for positional and angular characteristics of luminance of the optical waveguide (31),
comparing (S3) the simulated luminance distribution with the measured luminance distribution of the optical waveguide (31),
defining (S4) an optimum emission pattern for every pixel for every color of the display (30) based on the measured luminance distribution,
**characterised by**
realizing (S5) a lens geometry per pixel of the display (30) from the optimum emission pattern, and
processing (S6) a lens system per pixel of the display (30) based on the realized lens geometry in a digital process.

2. The method according to claim 1,
wherein the measurement of luminance distribution comprises the step of measuring the luminance distribution with respect to a plurality of predefined test points on the optical waveguide (31).

3. The method according to claim 1,
wherein the definition of optimum emission pattern comprises the step of defining an optimum emission pattern per pixel, per color of the display (30) with respect to the relative position of the display (30) and the optical waveguide (31) .

4. The method according to claim 1,
wherein the realization of lens geometry comprises the steps of:
defining, in ray tracing, the respective positioning of the display (30) and the optical waveguide (31),
optimizing an offset and a shape of the lens system thereby obtaining the lens geometry in arbitrary functions until the optimum emission pattern is achieved, and
translating the lens geometry into a digital pattern, thereby realizing digital arbitrary shaped optics.

5. The method according to claim 1,
wherein the processing of the lens system comprises the steps of:
depositing a low index material onto the surface of the light emitting elements, especially light emitting diodes,
dry-etching with a masking pattern based on the realized lens geometry, and
refilling with a high index material, where the index is preferably close to the index of the light emitting diode material.

6. The method according to any of claims 1 to 5,
wherein the method further comprises the steps of:
verifying the lens geometry per pixel in a Finite-difference time domain simulation, and/or
verifying the lens geometry for a cluster of pixels in a Finite-difference time domain simulation.

7. A system (50) for optimizing beam shaping of a display (30) comprising an array of light emitting elements, each corresponds to a pixel of said display, in order to adjust angular distribution of light pattern in an optical waveguide (31), the system (50) comprises:
simulation means (51) configured to simulate a luminance distribution for positional and angular characteristics of luminance of the optical waveguide (31),
measuring means (52) configured to measure a luminance distribution for positional and angular characteristics of luminance of the optical waveguide (31),
processing means (53) configured to compare the simulated luminance distribution with the measured luminance distribution of the optical waveguide (31), wherein the processing means (53) is further configured to define an optimum emission pattern for every pixel for every color of the display (30) based on the simulated and measured luminance distribution,
**characterised in that**
the processing means (53) is further configured to realize a lens geometry per pixel of the display (30) from the optimum emission pattern, and
wherein the system (50) further comprises fabrication means (54) configured to process a lens system per pixel of the display (30) based on the realized lens geometry in a digital process.

8. The system (50) according to claim 7,
wherein the processing means (53) is further configured to:
define, in ray tracing, the respective positioning of the display (30) and the optical waveguide (31), and
optimize an offset and a shape of the lens system thereby obtaining the lens geometry in arbitrary functions until the optimum emission pattern is achieved, and
translate the lens geometry into a digital pattern, thereby realizing digital arbitrary shaped optics.

9. The system (50) according to claim 7,
wherein the fabrication means (54) is further configured to process the lens system by:
depositing a low index material onto the surface of the light emitting elements, especially light emitting diodes,
dry-etching with a masking pattern based on the realized lens geometry, and
refilling with a high index material, where the index is preferably close to the index of the light emitting diode material.

10. A display (110) comprising an array of light emitting elements, each corresponds to a pixel arrangement (111) of the display (110), wherein the pixel arrangement (111) comprises:
a light emitting element (112) for each pixel, and
a lens system (113) comprising a digital arbitrary shaped optics optically coupled on top of each light emitting element (112), wherein the digital arbitrary shaped optics comprises at least a first layer (114) and a second layer (115),
**characterised in that**
the geometry of the lens system (113) is optimized with a method according to claims 1 to 6.

11. The display according to claim 10,
wherein the digital arbitrary shaped optics is composed of a high index material preferably close to the index of the light emitting element (112) material.

12. The display according to claim 10 or 11,
wherein the feature size of the digital arbitrary shaped optics is smaller than 1/4 of the smallest wavelength emitted by the light emitting elements (112).

## Patentansprüche

1. Ein Verfahren zum Optimieren der Strahlformung eines Displays (30), welches ein Array lichtemittierender, jeweils einem Pixel des Displays entsprechender Elemente aufweist, um die Winkelverteilung des Lichtmusters in einem Lichtwellenleiter (31) einzustellen, wobei das Verfahren die folgenden Schritte aufweist:
Simulieren der Leuchtdichteverteilung für die Positions- und Winkeleigenschaften der Leuchtdichte des Lichtwellenleiters (31),
Messen (S2) einer Leuchtdichteverteilung für die Positions- und Winkeleigenschaften der Leuchtdichte des Lichtwellenleiters (31),
Vergleichen (S3) der simulierten Leuchtdichteverteilung mit der gemessenen Leuchtdichteverteilung des Lichtwellenleiters (31),
Definieren (S4) eines optimalen Emissionsmusters für jedes Pixel und für jede Farbe des Displays (30) auf Grundlage der gemessenen Leuchtdichteverteilung,
**gekennzeichnet durch**
Realisieren (S5) einer Linsengeometrie für jedes Pixel des Displays (30) aus dem optimalen Emissionsmuster, und
Bearbeiten (S6) eines Linsensystems für jedes Pixel des Displays (30) auf Grundlage der realisierten Linsengeometrie in einem digitalen Prozess.

2. Das Verfahren nach Anspruch 1, wobei das Messen der Leuchtdichteverteilung den Schritt des Messens der Leuchtdichteverteilung in Bezug auf eine Mehrzahl vordefinierter Testpunkte auf dem Lichtwellenleiter (31) aufweist.

3. Das Verfahren nach Anspruch 1,
wobei das Definieren des optimalen Emissionsmusters den Schritt des Definierens eines optimalen Emissionsmusters für jedes Pixel und für jede Farbe des Displays (30) in Bezug auf die relative Position des Displays (30) und des Lichtwellenleiters (31) aufweist.

4. Das Verfahren nach Anspruch 1,
wobei das Realisieren der Linsengeometrie die folgenden Schritte aufweist:
Festlegen der jeweiligen Positionierung des Displays (30) und des Lichtwellenleiters (31) im Raytracing,
Optimieren eines Offsets und einer Form des Linsensystems, wodurch die Linsengeometrie in beliebigen Funktionen erhalten wird, bis das optimale Emissionsmuster erreicht ist, und
Übersetzen der Linsengeometrie in ein digitales Muster,
wodurch eine digitale, beliebig geformte Optik realisiert wird.

5. Das Verfahren nach Anspruch 1, wobei das Bearbeiten des Linsensystems die folgenden Schritte aufweist:
Aufbringen eines Materials mit niedrigem Brechungsindex auf die Oberfläche der lichtemittierenden Elemente, insbesondere der Leuchtdioden,
Trockenätzen mit einem auf der realisierten Linsengeometrie basierenden Maskenmuster, und
Auffüllen mit einem Material mit hohem Brechungsindex, wobei der Brechungsindex vorzugsweise in der Nähe des Brechungsindexes des Materials der Leuchtdioden liegt.

6. Das Verfahren nach einem der Ansprüche 1 bis 5,
wobei das Verfahren ferner die folgenden Schritte aufweist:
Verifizieren der Linsengeometrie für jedes Pixel in einer Finite-Differenzen-Zeitbereichssimulation, und/oder
Verifizieren der Linsengeometrie eines Clusters von Pixeln in einer Finite-Differenzen-Zeitbereichssimulation.

7. Ein System (50) zum Optimieren der Strahlformung eines Displays (30), welches ein Array lichtemittierender, jeweils einem Pixel des Displays entsprechender Elemente aufweist, um die Winkelverteilung des Lichtmusters in einem optischen Wellenleiter (31) einzustellen, wobei das System (50) aufweist:
eine Simulationseinrichtung (51), die so ausgebildet ist, dass sie eine Leuchtdichteverteilung für Positions- und Winkeleigenschaften der Leuchtdichte des Lichtwellenleiters (31) simuliert,
eine Messeinrichtung (52), die so ausgebildet ist, dass sie eine Leuchtdichteverteilung für Positions- und Winkeleigenschaften der Leuchtdichte des Lichtwellenleiters (31) misst,
eine Bearbeitungseinrichtung (53), die so ausgebildet ist, dass sie die simulierte Leuchtdichteverteilung mit der gemessenen Leuchtdichteverteilung des Lichtwellenleiters (31) vergleicht,
wobei die Bearbeitungseinrichtung (53) ferner so ausgebildet ist, dass sie für jedes Pixel und für jede Farbe des Displays (30) auf der Grundlage der simulierten und gemessenen Leuchtdichteverteilung ein optimales Emissionsmuster definiert,
**dadurch gekennzeichnet, dass**
die Bearbeitungseinrichtung (53) weiterhin ausgebildet ist, um aus dem optimalen Emissionsmuster für jedes Pixel des Displays (30) eine Linsengeometrie zu realisieren, und
wobei das System (50) ferner eine Herstellungseinrichtung (54) aufweist, die so ausgebildet ist, dass sie für jedes Pixel des Displays (30), auf Grundlage der realisierten Linsengeometrie, ein Linsensystem in einem digitalen Prozess bearbeitet.

8. Das System (50) nach Anspruch 7,
wobei die Bearbeitungseinrichtung (53) weiterhin ausgebildet ist, um:
die jeweilige Positionierung des Displays (30) und des Lichtwellenleiters (31) im Raytracing zu definieren, und
einen Offset und eine Form des Linsensystems zu optimieren, wodurch die Linsengeometrie in beliebigen Funktionen erhalten wird, bis das optimale Emissionsmuster erreicht ist, und um
die Linsengeometrie in ein digitales Muster zu übersetzen, wodurch eine digitale, beliebig geformte Optik realisiert wird.

9. Das System (50) nach Anspruch 7,
wobei die Herstellungseinrichtung (54) weiterhin so ausgebildet ist, dass sie das Linsensystem bearbeitet durch:
Aufbringen eines Materials mit niedrigem Brechungsindex auf die Oberfläche der lichtemittierenden Elemente, insbesondere der Leuchtdioden,
Trockenätzen mit einem Maskenmuster, auf Grundlage der realisierten Linsengeometrie, und
Auffüllen mit einem Material mit hohem Brechungsindex, wobei der Brechungsindex vorzugsweise nahe dem Brechungsindex des Materials der Leuchtdioden liegt.

10. Ein Display (110) mit einem Array aus lichtemittierenden, jeweils einer Pixelanordnung (111) des Displays (110) entsprechenden Elementen, wobei die Pixelanordnung (111) aufweist:
ein lichtemittierendes Element (112) für jedes Pixel, und
ein Linsensystem (113), welches eine digitale, beliebig geformte Optik aufweist, die optisch mit der Oberseite jedes lichtemittierenden Elements (112) gekoppelt ist, wobei die digitale, beliebig geformte Optik zumindest eine erste Schicht (114) und eine zweite Schicht (115) aufweist,
**dadurch gekennzeichnet, dass**
die Geometrie des Linsensystems (113) mit einem Verfahren nach einem der Ansprüche 1 bis 6 optimiert wird.

11. Das Display nach Anspruch 10, wobei die digitale beliebig geformte Optik aus einem Material mit hohem Brechungsindex besteht, der vorzugsweise nahe am Brechungsindex des Materials des lichtemittierenden Elements (112) liegt.

12. Das Display nach Anspruch 10 oder 11, wobei die Abmessung der digitalen beliebig geformten Optik kleiner als 1/4 der kleinsten von den lichtemittierenden Elementen (112) emittierten Wellenlänge ist.

## Revendications

1. Un procédé pour optimiser la mise en forme de faisceau d'un affichage (30) comportant une matrice d'éléments électroluminescents, chacun correspondant à un pixel dudit affichage, afin d'ajuster une répartition angulaire d'un motif lumineux dans un guide d'ondes optique (31), dans lequel le procédé comporte les étapes consistant à :
simuler (S1) une répartition de luminance pour des caractéristiques de positionnement et d'angle de luminance du guide d'ondes optique (31),
mesurer (S2) une répartition de luminance pour des caractéristiques de positionnement et d'angle de luminance du guide d'ondes optique (31),
comparer (53) la répartition de luminance simulée avec la répartition de luminance mesurée du guide d'ondes optique (31),
définir (54) un motif d'émission optimal pour chaque pixel pour chaque couleur de l'affichage (30) sur la base de la répartition de luminance mesurée,
**caractérisé par** :
réaliser (S5) une géométrie de lentille par pixel de l'affichage (30) à partir du motif d'émission optimal, et
traiter (S6) un système de lentilles par pixel de l'affichage (30) sur la base de la géométrie de lentille réalisée dans un processus numérique.

2. Le procédé selon la revendication 1,
dans lequel la mesure de la répartition de luminance comporte l'étape consistant à mesurer la répartition de luminance par rapport à une pluralité de points de test prédéfinis sur le guide d'ondes optique (31).

3. Le procédé selon la revendication 1,
dans lequel la définition d'un motif d'émission optimal comporte l'étape consistant à définir un motif d'émission optimal par pixel, par couleur de l'affichage (30) par rapport à la position relative de l'affichage (30) et du guide d'ondes optique (31).

4. Le procédé selon la revendication 1,
dans lequel la réalisation de la géométrie de lentille comporte les étapes consistant à :
définir, par tracé de rayons, le positionnement respectif de l'affichage (30) et du guide d'ondes optique (31),
optimiser un décalage et une forme du système de lentilles, en obtenant ainsi la géométrie de lentille dans des fonctions arbitraires jusqu'à ce que le motif d'émission optimal soit obtenu, et
convertir la géométrie de lentille en un motif numérique, en réalisant ainsi une optique numérique de forme arbitraire.

5. Le procédé selon la revendication 1,
dans lequel le traitement du système de lentilles comporte les étapes consistant à :
déposer un matériau à faible indice sur la surface des éléments électroluminescents, en particulier des diodes électroluminescentes,
réaliser une gravure sèche avec un motif de masquage sur la base de la géométrie de lentille réalisée, et
recharger avec un matériau à indice élevé, où l'indice est de préférence proche de l'indice du matériau de diode électroluminescente.

6. Le procédé selon l'une quelconque des revendications 1 à 5,
dans lequel le procédé comporte en outre les étapes consistant à :
vérifier la géométrie de lentille par pixel dans une simulation dans le domaine temporel par différences finies, et/ou
vérifier la géométrie de lentille pour une grappe de pixels dans une simulation dans le domaine temporel par différences finies.

7. Un système (50) pour optimiser la mise en forme de faisceau d'un affichage (30) comportant une matrice d'éléments électroluminescents, chacun correspondant à un pixel dudit affichage, afin d'ajuster une répartition angulaire d'un motif lumineux dans un guide d'ondes optique (31), le système (50) comportant :
des moyens de simulation (51) configurés pour simuler une répartition de luminance pour des caractéristiques de positionnement et d'angle de luminance du guide d'ondes optique (31),
des moyens de mesure (52) configurés pour mesurer une répartition de luminance pour des caractéristiques de positionnement et d'angle de luminance du guide d'ondes optique (31),
des moyens de traitement (53) configurés pour comparer la répartition de luminance simulée avec la répartition de luminance mesurée du guide d'ondes optique (31),
dans lequel les moyens de traitement (53) sont en outre configurés pour définir un motif d'émission optimal pour chaque pixel pour chaque couleur de l'affichage (30) sur la base de la répartition de luminance simulée et mesurée,
**caractérisé en ce que**
les moyens de traitement (53) sont en outre configurés pour réaliser une géométrie de lentille par pixel de l'affichage (30) à partir du motif d'émission optimal, et
dans lequel le système (50) comporte en outre des moyens de fabrication (54) configurés pour traiter un système de lentilles par pixel de l'affichage (30) sur la base de la géométrie de lentille réalisée dans un processus numérique.

8. Le système (50) selon la revendication 7,
dans lequel les moyens de traitement (53) sont en outre configuré pour :
définir, par tracé de rayons, le positionnement respectif de l'affichage (30) et du guide d'ondes optique (31), et
optimiser un décalage et une forme du système de lentilles, en obtenant ainsi la géométrie de lentille dans des fonctions arbitraires jusqu'à ce que le motif d'émission optimal soit obtenu, et
convertir la géométrie de lentille en un motif numérique, en réalisant ainsi une optique numérique de forme arbitraire.

9. Le système (50) selon la revendication 7,
dans lequel les moyens de fabrication (54) sont en outre configurés pour traiter le système de lentilles par les étapes consistant à :
déposer un matériau à faible indice sur la surface des éléments électroluminescents, en particulier des diodes électroluminescentes,
réaliser une gravure sèche avec un motif de masquage sur la base de la géométrie de lentille réalisée, et
recharger avec un matériau à indice élevé, où l'indice est de préférence proche de l'indice du matériau de diode électroluminescente.

10. Un affichage (110) comportant une matrice d'éléments électroluminescents, chacun correspondant à un agencement de pixels (111) de l'affichage (110), dans lequel l'agencement de pixels (111) comporte :
un élément électroluminescent (112) pour chaque pixel, et
un système de lentilles (113) comportant une optique numérique de forme arbitraire couplée optiquement au-dessus de chaque élément électroluminescent (112),
dans lequel l'optique numérique de forme arbitraire comporte au moins une première couche (114) et une seconde couche (115),
**caractérisé en ce que**
la géométrie du système de lentilles (113) est optimisée avec un procédé selon les revendications 1 à 6.

11. Affichage selon la revendication 10,
dans lequel l'optique numérique de forme arbitraire est composée d'un matériau à indice élevé, de préférence proche de l'indice du matériau d'élément électroluminescent (112).

12. Affichage selon la revendication 10 ou 11,
dans lequel la taille de caractéristique de l'optique numérique de forme arbitraire est inférieure à 1/4 de la plus petite longueur d'onde émise par les éléments électroluminescents (112).
